# EUROPEAN PATENT APPLICATION

(11) **EP 1 724 641 A1**
(43) Date of publication of application: **22.11.2006**
(21) Application number: 05010968.5
(22) Date of filing: 20.05.2005
(51) Int. Cl.: G03F 7/20

(54) **Lithograpic projection apparatus and method of exposing a semiconductor wafer with a pattern from a mask**

(71) Applicant: Infineon Technologies AG, 81669 München (DE)
(72) Inventor: Nölscher, Christoph, 01109 Dresden (DE)
(74) Representative: Epping - Hermann - Fischer

(57) **Abstract**

A single through-the-focus exposure of a semiconductor wafer (51) is achieved by a lithographic projection apparatus, which has the capability of generating an exposure profile comprising substantially two separate portions (20, 21), or maxima, of exposure light (40). Both portions (20, 21) of the light are directed to the mask (50), on which the pattern is formed. The mask (50) is thus exposed coincidently, but on separately located surface positions. Two different patterned portions (40, 41) of the exposure light (40) are then focused onto the wafer (51). In a preferred embodiment, the two portions (20, 21) are generated by means of a double slit (30, 31). The exposure is combined with a continuous through-the-focus exposure, wherein a tilt is applied to the wafer stage.

## Description

The invention relates to lithographic projection apparatus and further to exposing a semiconductor wafer with a pattern from a mask. The invention particularly relates to wafer scanning apparatus comprising slit members used to transmit a portion of the incident light generated by an illumination source towards a mask, which is scanned by said portion. The invention also relates to focus variation methods performed during an exposure.

In fabricating integrated circuits multiple patterns are projected by means of exposure each sequentially from a mask or reticle into resist layers formed on a surface of a semiconductor wafer. Each of the exposures is usually followed by steps of processing the layer, which may relate to baking and developing the resist layer, etching the pattern formed in the resist further into an underlying layer, removing the resist etc. such that a number of levels of the integrated circuit are sequentially formed.

With continuously increasing densities of structures within patterns, the resolution capability of exposure tools has been reached, which happens when structure widths become comparable to the wavelength of an exposure light, which is used to project the pattern onto the wafer. Accordingly resolution enhancement techniques have been developed to push the dimensional limits in forming structures to even smaller structure widths, or pitches of periodic patterns. These techniques relate for example to the use of half-tone or alternating phase shift masks in an exposure, or to apply optical proximity corrections to the mask layout.

The group of critical patterns to be transferred from a mask to a semiconductor wafer comprises, among others, contact hole patterns. Contact holes are generally formed to connect different layers of an integrated circuit and may comprise periodically arranged square-like or elongated openings, e.g., as in the case of dynamic random access memories (DRAM), wherein the contact holes have a particularly critical width with respect to the resolution limit of a respective exposure tool.

As compared with lines and spaces patterns, contact hole patterns are less suited for the alternating phase shift mask technique, although it has been shown, that an improvement with respect to conventional mask lithography may be accomplished in Schenker et al. "Alternating Phase Shift Masks for Contact Patterning" in: Optical Microlithography XVI, Proceedings of SPIE, vol. 5040 (2003). According to an analysis provided in that document, additional constraints are placed on a lithographic projection step when tight pitches, i.e. large structure densities have to be manufactured. These constraints particularly relate to accurate phase control, defect inspection and specific repair requirements.

Thus, the application of specific mask types such as phase shift masks or the application of specific features within the pattern such as assist features leads to considerable limitations particularly with respect to depth of focus (DoF), etc. Further, the application of specific mask types necessitates an extraordinarily high precision with regard to a patterning process performed on a corresponding mask substrate.

In order to improve the process window when lithographically projecting contact hole patterns onto wafers, the use of so-called Bessel contacts has been proposed by Schellenberg et al. in: "Optimization of Real Phase Mask Performance", 11th Annual BACUS Symposium on Photomask Technology, SPIE vol. 604 (1991), page 274-296. According to that option, contact hole openings on the mask are provided with thin rim-like phase edges adjacent to the boundary of such openings. However, this option has only very limited application ranges and is further difficult to realize in mask manufacturing processes.

Another approach to improve process windows relates to pupil filtering, as described by Gräupner et al. in: "Solutions for Printing Sub100 nm Contacts with ArF", Optical Microlithography XV Proceedings of SPIE Vol. 4691, pp. 503-514 (2002). Therein, the formation of tri-tone contacts is suggested in the case only of large pitches (p > 400 nm) while the application of pupil filtering, especially transmission filtering, within the pupil plane of the projection lens is not considered to improve the process window. Concurrently, the machine complexity and wafer throughput increases therefrom. As a consequence the approach of pupil filtering is also of limited use with respect to transferring contact hole patterns.

Another approach relates to focus drilling. A lithographic step is divided into a number of exposure steps, each step being performed with another focus offset of the wafer with respect to a focal plane of the projection lens. This method is also called "focus latitude enhancement exposure" (FLEX) and is disclosed, e.g., in Fukuda, H., et al. "Improvement of defocus Tolerance in a Half-Micron Optical Lithography by the Focus Latitude Enhancement Exposure Method: Simulation and Experiment", J. Vac. Sci. Technol. B.7 (4) July/August 1989, P.667-674. As is pointed out in that paper, the drilling or variation of focus is particularly promising with respect to contact holes. However, a problem arises with respect to the realization as a single exposure (throughput issues) and further the control of that exposure (loss of focus accuracy due to repeated auto focus adjustment for each exposure).

It has thus been proposed to apply an x- or y-tilt to the wafer stage, which results in a single through-the-focus exposure (Lalovic, E. et al. "Depth of Focus Enhancement by Wavelength Modulation: Can We RELAX and Improve Focus Latitude?", Proceedings of 40^{th} Interface Symposium Conference 2003), wherein the movement of a scanning in x- or y-direction is adapted to the tilt level.

According to that method, the wafer to be exposed is moved within a plane, which is x-tilted with respect to the focal plane of the projection lens system of the wafer scanning tool. Consequently, when a point on the wafer surface enters the area which is exposed to the patterning light due to the slit of the tool, it starts at a minimum focus value, which then continuously increases until this point leaves the exposed area. In this phase, the exposure of this specific point on the wafer surface has acquired a maximum focus value.

The method considerably increases the depth of focus (DOF) particularly with respect to contact or via hole patterns at the cost of the contrast and exposure latitude (dose tolerance range). A stage tilt of 1.000 nm with respect to opposed edges of a slit having a short slit side extension (SSSE, herein also denoted as the "width" of a slit) of 8 mm is typically applied for contact hole patterns. That tilt provides a reasonable balance between DOF-gain and EL-loss (exposure latitude).

However, the method, which is also denoted CDP (Nikon Corp.: "continuous DOF expansion exposure procedure") suffers from the following issues:
a) the limited dynamic leveling range of the exposure during the tilted scanning;
b) the increase in depth of focus (DoF) is smaller than for, e.g., 2-3 exposures applied with a multiple focus offset according to the FLEX-method.

From the foregoing, it becomes clear that any known approach of driving sizes of structures in contact hole patterns nearer to the resolution limit suffers from one of: process window decrease, throughput reduction, severe constraints on mask manufacturing, constraints on exposure tool design, etc.

It is thus an object of the present invention to increase the process window, particularly with respect to depth of focus (DoF) of a lithographic structuring step.

It is a further object of the invention to increase the throughput when performing an exposure step.

It is still a further object of the invention to increase the quality of a lithographic projection step.

The object is solved by a lithographic projection apparatus for exposing a semiconductor wafer with a pattern from a mask, comprising:
- an illumination source for directing exposure light onto a scanning member;
- the scanning member having a first slit and at least a second slit for transmitting a first and a second portion of said incident exposure light to the mask, respectively, both slits being arranged substantially parallel with respect to each other;
- a stage for moving said mask with respect to said scanning member within a scan direction perpendicular to an optical axis of the projection apparatus, such that the same area of the pattern on the mask is sequentially scanned with said portions of said exposure light;
- a projection lens system for focussing said illuminated portions of the pattern of said mask onto said semiconductor wafer;
- a stage for moving said semiconductor wafer in a direction with respect to said slit, such that said wafer is exposed with said scanned portions of said pattern of said mask.

The object is further solved by a lithographic projection apparatus for exposing a semiconductor wafer with a pattern from a mask, comprising:
- an illumination source for directing exposure light onto a scanning member;
- the scanning member having a slit confined by opposite slit edges, said slit being arranged to transmit portions of said incident exposure light to the mask according to a non-uniform transmission profile, said transmission profile of said slit having maximum transmission portions adjacent to the opposite slit edges of said slit;
- a stage for moving said mask with respect to said scanning member within a scan direction perpendicular to an optical axis of the projection apparatus, such that the same area of the pattern on the mask is sequentially scanned with said portions of said exposure light;
- a projection lens system for focussing said illuminated portions of the pattern of said mask onto said semiconductor wafer;
- a stage for moving said semiconductor wafer in a direction with respect to said slit, such that said wafer is exposed with said scanned portions of said pattern of said mask.

A lithographic projection apparatus for exposing a semiconductor wafer with a pattern from a mask, comprising:
- an illumination source for directing an exposure light onto a scanning member having a slit confined by opposite slit edges, the illumination source being arranged to direct said exposure light with an intensity profile, which has maximum intensity portions adjacent to the opposite slit edges of said slit;
- the scanning member having said slit confined by said opposite slit edges, for transmitting said incident exposure light to the mask according to said intensity profile;
- a stage for moving said mask with respect to said scanning member within a scan direction perpendicular to an optical axis of the projection apparatus, such that the same area of the pattern on the mask is sequentially scanned with said portions of said exposure light;
- a projection lens system for focussing said illuminated portions of the pattern of said mask onto said semiconductor wafer;
- a stage for moving said semiconductor wafer in a direction with respect to said slit, such that said wafer is exposed with said scanned portions of said pattern of said mask.

Further advantageous aspects and embodiments are evident from the appended claims.

An single through-the-focus exposure of a semiconductor wafer is achieved by a lithographic projection apparatus, which has the capability of generating an exposure profile comprising substantially two separate portions, or maxima, of exposure light. Both portions of the light are directed to the mask, on which the pattern is formed. The mask is thus exposed coincidently, but on separately located mask surface positions, with two different portions of the light. The imaging is preferably treated independently because the slits are macroscopically separated and therefore interference effects are neglected within this disclosure.

This feature of generating two different portions of the incident light is accompanied with the application of an x- or y-tilt to the wafer stage in order to effect the single through-the-focus exposure. The two portions of the light represent an intensity or transmission profile of the slit. This profile is provided within scan direction of the mask with respect to the slit. I.e., the profile is arranged along the short slit side extension (SSSE). Preferably, the profile is uniform along the long side slit extension, i.e. the intensity of light on the mask due to each of the portions is uniform along a line transverse to the scan direction.

Consequently, the portions of the light follow each other during the scanning movement on the mask surface. The same is valid, then, on the semiconductor wafer. However, similar to the case according to prior art, where precisely one uniform slit intensity distribution fully covers a continuous focus range due to the x- or y-tilt, each of the portions of the slit according to the invention is attached to its own maximum and minimum focus values with respect to the wafer. As these portions will be considerably more narrow than the broad slit according to prior art, the resulting exposure is effected at two distinct and narrow focus ranges.

It has been found that the contrast of the exposure is considerably improved with regard to the single exposure through-the-focus method according to prior art. In this respect the invention utilizes the advantage of the double exposure FLEX method by exposing the wafer at distinct focus settings. An effect of a smearing-out of the intensity profile within an aerial image achieved on the wafer is advantageously reduced.

Contrary to FLEX, in the present disclosure a single exposure is achieved with the result that focus adjustments, which inevitably introduce focus errors to the exposure, are not necessary. Accordingly, the quality of the exposure is increased. The invention thus effectively combines the advantages of the FLEX- and CDP-method according to prior art.

In one aspect, the apparatus has a slit member with a double slit. Both slits are may be arranged in parallel with respect to its length direction, i.e. long side. The intensity or transmission profile provided by this arrangement of slits is simply a double peak. It is not ruled out, that those parts of the slit member positioned between both slits may be semitransparent in order to create a moderate profile. However, in order to improve the contrast enhancement, the short side slit length of each of the multiple slits should be chosen to be small with respect to a sum of all slits and the intervening areas, e.g., less than 1/4 as compared with a conventional slit.

In another aspect, the only existing single slit of the apparatus is arranged to transmit the light according to a transmission profile. This can be achieved by a Quartz plate with patterned absorbing material, like Cr, or with non-uniform evaporated Cr-layer.

The resulting transmission profile has two peaks adjacent to the slit edges opposite to each other. The slit edges considered here are those along the long sides of the slit. A central area of the slit then has a minimum value of transmission. In one embodiment, the profile is symmetric in order to balance the focus settings applied to the exposure. However, an asymmetric profile - or asymmetric slit widths according to the previous aspect are not ruled out. Both slits are translational symmetric with respect to each other.

Another aspect deals with generating the double peak profile by means of the illumination source. In particular, the (single) slit is not exposed uniformly but with two intensity maxima, each of the maximas being disposed near one of the opposite slit edges along the long side of the slit. Both maxima define two portions of the exposure light which lead to a sequential illumination of the mask pattern. As in the previous case, the slit centre may also have an intensity distribution which, however, comprises a minimum value.

The invention will become more clear with respect to certain embodiments when taken in conjunction with the accompanying drawings. Therein,
- Figure 1: shows a comparison of intensity distributions according to the invention (d-e) with those of prior art (a-c);
- Figure 2: shows a comparison of an embodiment using a double slit according to the invention (b) with those of prior art (a);
- Figure 3: show embodiments according to the present invention with a modified illumination source.

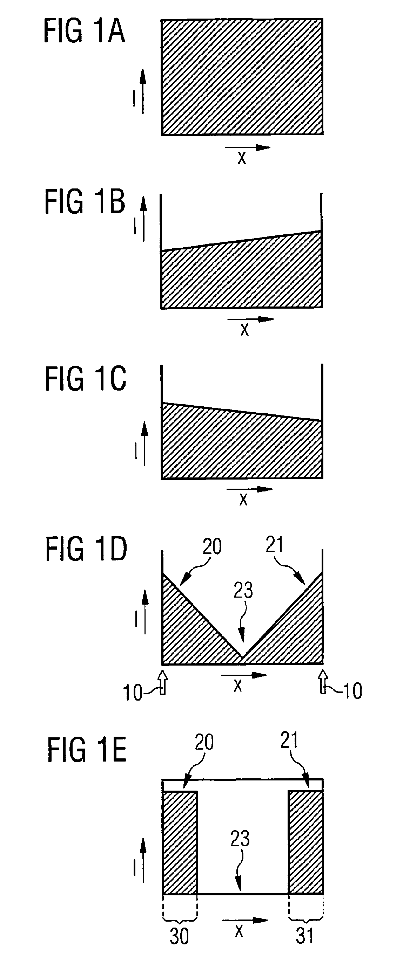

Figure 1 shows examples of intensity or transmission profiles according to prior art (a)-(c) and according to the invention (d)-(e). In the graphs the intensity is plotted versus the short side slit axis denoted as "x". The profile along the long side axis is considered be uniform for each specific x-value. Fig. 1a shows the case of a single slit with a uniform profile as known from prior art. For example the slit has a width (SSSE) of 8 mm.

Figs. 1b-c show non-uniform intensity distributions, which may occur in real present illumination systems.

Fig. 1d shows a schematic intensity distribution according to an embodiment of the invention. At slit edges 10 a maximum value of the intensity I is accomplished leading to portions 20, 21 of the exposure light, which will have separate locations x when applied to the mask. Both portions 20, 21 are separated by a minimum 23 in a central area of the slit. The minimum may be formed by, e.g., a shaded chrome blank, which has its largest layer thickness correspondingly in the centre. Alternatively the intensity distribution is achieved by tuning the light intensity incident on the slit or on the mask.

Fig. le schematically shows a further embodiment of the invention. Herein, two slits 30, 31 forming a double slit are realized to provide a double peak profile with portions 20, 21. The minimum in the centre is fully shaded by the slit member operating as a blade.

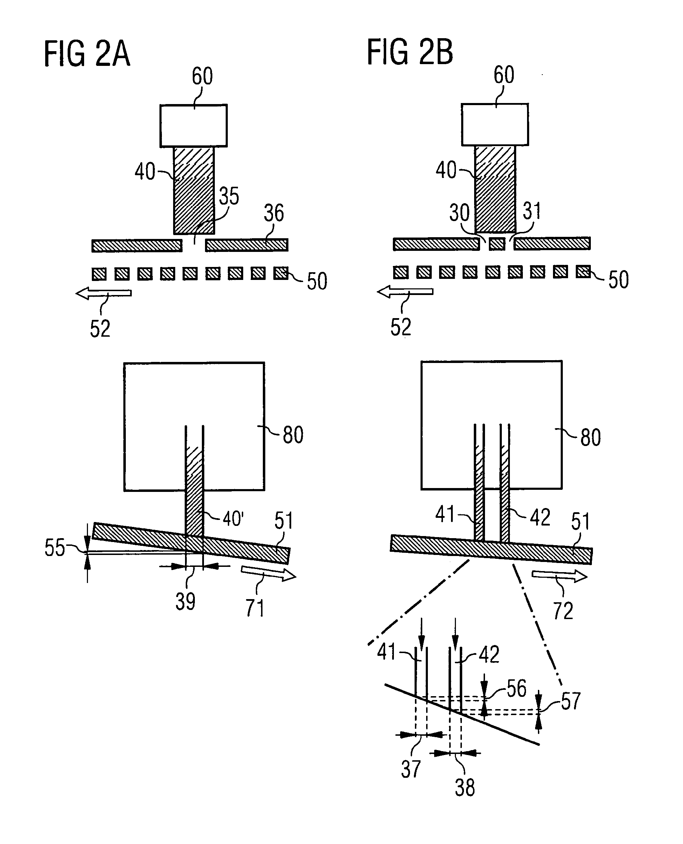

Fig. 2a shows an example of a single exposure through-the-focus method according to prior art. An illumination source 60 generates exposure light 40 and directs it to single slit 35 formed in slit member 36. Reticle 50 is scanned in scan direction 52 with respect to slit 35. A portion of the exposure light 40 is transmitted by slit 40 to expose the pattern formed on reticle 50. The thus illuminated pattern is transferred via the projection lens system 80 to the surface of the wafer 51. Diffraction orders from the mask patterns are not shown for clarity.

The wafer 51 is tilted by a height 55 of 1.000 nm per width 39 of 8 mm. The height 55 represents the z-difference of the right to the left slit edge and the width 39 represents the short side slit extension. A scan movement 71 of the wafer is fully performed within a plane defined by that tilt. Each point on the wafer surface undergoes the same range of focus settings defined by the tilt as given by numerals 39, 55.

Fig. 2b shows an embodiment of the invention which relates to the intensity or transmission profile shown in Fig le. Like numerals denote the same entities as shown in Fig. 2a. A difference with respect to Fig. 2a, however, is evident from the presence of two slits 30, 31. Two portions 41, 42 of the exposure light result from this double slit, which are incident on the surface of the wafer. The widths 37, 38 of the slits 30, 31 amount to 2 mm each. Both slits are separated by 4 mm. The largest slit edge distance thus is 8 mm. An optimum height difference for the slit edges is found to 400 nm, which means, that the tilt of the scan direction 72 according to this embodiment may be expressed as 400 nm per 8 mm.

Consequently, the tilt according to the invention is less than half of that tilt, which is commonly used in prior art. As a result, the dynamic leveling range of the wafer stage is advantageously increased.

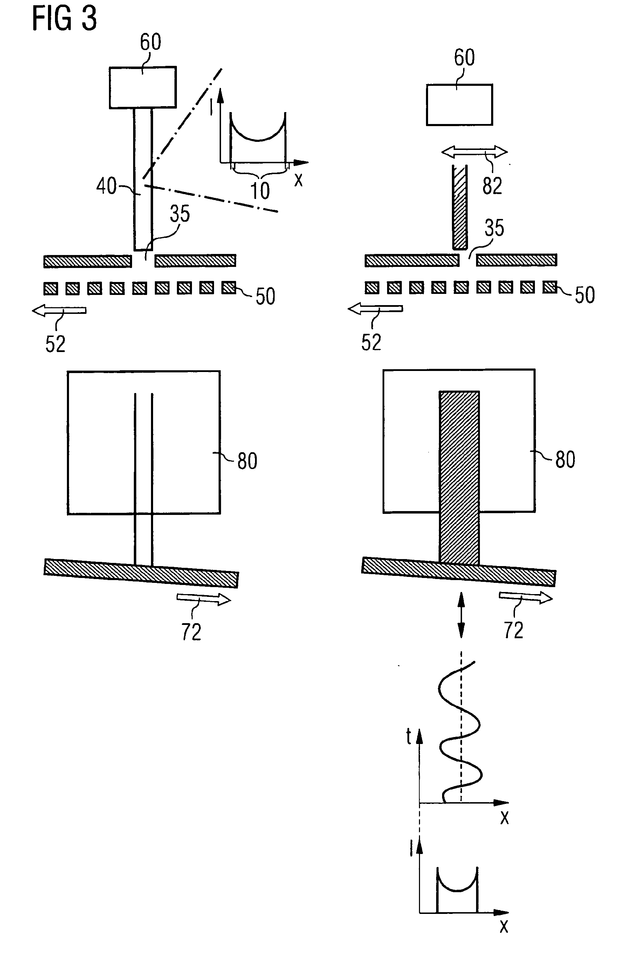

Fig. 3 shows further alternative embodiments of the invention. The tilted stage arrangement is the same as that shown in Fig. 2b. In Fig. 3a, the exposure light 40 is arranged show a larger intensity distribution at near the slit edges 10. This may be accomplished by a specific arrangement of the illumination lens system.

Alternatively, the illumination lens system may have elements, which periodically move a focused light beam with uniform intensity distribution, which has a diameter of less than the slit width. The movement is advantageously of the sine form. The beam then has a longer duration at the return points as illustrated in the diagram in the upper left of Fig. 3b. As a result, the intensity averaged over several cycles is larger at the return points, which are set to the slit edge positions. The frequency of the periodic movement is much higher (>10x) than that calculated from slit width/scan speed.

### List of Reference Numerals:

- 10: slit edge
- 20, 21: portions of exposure light
- 23: minimum in intensity distribution along slit
- 30, 31: slits of double slit
- 35: single slit
- 36: slit member, blade
- 39: width
- 40: exposure light
- 41, 42: portions of exposure light
- 50: reticle
- 51: wafer
- 52: scan direction (mask)
- 55: height
- 60: illumination source
- 71: scan movement (tilted wafer): prior art
- 72: scan movement (tilted wafer): invention
- 80: projection lens system

## Claims

1. A lithographic projection apparatus for exposing a semiconductor wafer (51) with a pattern from a mask (50), comprising:
- an illumination source (60) for directing incident exposure light (40) onto a scanning member (36);
- the scanning member (36) having a first slit (30) and at least a second slit (31) for transmitting a first and a second portion (20, 21) of said incident exposure light (40) to the mask (50);
- a stage for moving said mask (50) with respect to said scanning member (36) within a scan direction (52) perpendicular to an optical axis of the projection apparatus, such that the same area of the pattern on the mask is sequentially scanned with said portions (20, 21) of said exposure light (40);
- a projection lens system (80) for focussing illuminated portions (40, 41) of the pattern of said mask (50) onto said semiconductor wafer (51);
- a stage for moving said semiconductor wafer (51) in a direction (72) with respect to said slits (30, 31), such that said wafer (51) is exposed with said scanned portions (40, 41) of said pattern of said mask (50).

2. The lithographic projection apparatus according to claim 1, wherein said stage for moving said semiconductor wafer (51) is arranged to be moved in a direction (72) that is tilted with respect to the scan direction (52) of the mask (50) for providing a focus drilling capability during an exposure.

3. The lithographic projection apparatus according to claim 1, wherein both slits (30, 31) are translational symmetric with respect to each other.

4. The lithographic projection apparatus according to claims 1 or 3, wherein the first (30) and the second slit (31) have a rectangular shape.

5. The lithographic projection apparatus according to claims1 or 3, wherein the first (30) and the second slit (31) have shapes as ellipsoidal ring segments.

6. The lithographic projection apparatus according to claim 1, wherein the first (30) and the second slit (31) are separated by an area of said scanning member (36), said area being partially transparent with respect to said incident exposure light (40).

7. The lithographic projection apparatus according to claim 1, wherein the first (30) and the second slit (31) each have a width less or equal to 2 mm.

8. The lithographic projection apparatus according to claim 1, wherein the first (30) and the second slit (31) are separated from other by a distance of at least 4 mm.

9. Method to expose a semiconductor wafer with a pattern from a mask (50), comprising the steps of:
- providing the mask (50) and the wafer (51) to a lithographic projection apparatus;
- generating an exposure light (40) using an illumination source (60);
- directing an exposure light (40) onto a scanning member (36) of the apparatus having a first slit (30) and at least a second slit (31) for transmitting a first (20) and a second portion (21) of said incident exposure light (40) to the mask (50);
- moving the mask (50) with said pattern in a scan direction (52) perpendicular to an optical axis of the projection apparatus, such that the same area of the pattern on the mask (50) is sequentially scanned with said first (20) and second portion (21) of said exposure light;
- focusing respective portions (40, 41) of exposure light due to the scanned areas of the pattern of the mask (50) into a focal plane using a projection lens (80) of the projection apparatus;
- moving the semiconductor wafer (51) in a direction (72) having a tilted angle with respect to said scan direction (52) through the focal plane, such that said wafer is exposed sequentially with said first portion (40) and with the second portion (41) each at a constant and distinct focus position.

10. A lithographic projection apparatus for exposing a semiconductor wafer (51) with a pattern from a mask (50), comprising:
- an illumination source (80) for directing exposure light (40) onto a scanning member (36);
- the scanning member (36) having a slit (35) confined by opposite slit edges (10), said slit (35) being arranged to transmit said incident exposure light (40) to the mask (50) according to a non-uniform transmission profile, which has maximum transmission portions (20, 21) adjacent to the opposite slit edges (10) of said slit (35);
- a stage for moving said mask (50) with respect to said scanning member (36) within a scan direction (52) perpendicular to an optical axis of the projection apparatus, such that the same area of the pattern on the mask (50) is sequentially scanned with said maximum transmission portions (20, 21) of said exposure light;
- a projection lens system for focussing portions (40, 41) of the exposure light due to the illuminated area of the pattern of said mask (50) onto said semiconductor wafer (51);
- a stage for moving said semiconductor wafer (51) in a direction (72) with respect to said slit (35), such that said wafer (51) is sequentially exposed with said portions (40, 41).

11. A lithographic projection apparatus for exposing a semiconductor wafer (51) with a pattern from a mask (50), comprising:
- an illumination source (60) for directing an exposure light (40) onto a scanning member (36) having a slit (35) confined by opposite slit edges (10), the illumination source (60) being arranged to direct said exposure light (40) with an intensity profile, which has two maximum intensity portions (20, 21) adjacent to the opposite slit edges (10) of said slit (35);
- the scanning member (36) having said slit (35) confined by said opposite slit edges (10), for transmitting said incident exposure light to the mask (50) according to said intensity profile;
- a stage for moving said mask (50) with respect to said scanning member (36) within a scan direction (52) perpendicular to an optical axis of the projection apparatus, such that the same area of the pattern on the mask is sequentially scanned with said maximum intensity portions (20, 21) of said exposure light;
- a projection lens system (80) for focussing portions (40, 41) of the exposure light (40) due to the illuminated areas of the pattern of said mask onto said semiconductor wafer (51);
- a stage for moving said semiconductor wafer (51) in a direction (72) with respect to said slit (35), such that said wafer (51) is sequentially exposed with said portions (40, 41) of exposure light (40).
